Europäisches Patentamt

European Patent Office

Office européen des brevets

(19)

(11) Numéro de publication : **0 078 089 B1**

(12) **FASCICULE DE BREVET EUROPÉEN**

(45) Date de publication du fascicule du brevet :
**12.02.86**

(51) Int. Cl.⁴ : **H 01 L 27/01**

(21) Numéro de dépôt : **82201340.5**

(22) Date de dépôt : **27.10.82**

(54) **Procédé de réalisation d'un pont d'alimentation soumis à des surcharges importantes et pont d'alimentation réalisé suivant ce procédé.**

(30) Priorité : **28.10.81 FR 8120239**

(43) Date de publication de la demande :
**04.05.83 Bulletin 83/18**

(45) Mention de la délivrance du brevet :
**12.02.86 Bulletin 86/07**

(84) Etats contractants désignés :
**BE CH DE FR GB IT LI SE**

(56) Documents cités :
**EP-A- 0 048 940
GALVANOTECHNIK, vol. 69, no. 11, novembre 1978, pages 978-985, Saulgau (DE); R.R. DEAN et al.: "Herstellung von Dickfilm-Hybriden Zinn in der Elektronik".**

(73) Titulaire : **TELECOMMUNICATIONS RADIOELECTRI-QUES ET TELEPHONIQUES T.R.T.
88, rue Brillat Savarin
F-75013 Paris (FR)**

(72) Inventeur : **Forestier, Alain
Societe Civile S.P.I.D. 209 rue de l'Université
F-75007 Paris (FR)**

(74) Mandataire : **Chaffraix, Jean et al
Société Civile S.P.I.D. 209, rue de l'Université
F-75007 Paris (FR)**

# 0 078 089

**Description**

L'invention concerne un procédé de réalisation d'un pont d'alimentation pouvant être soumis à des surcharges importantes.

L'éventualité de telles surcharges se présente par exemple en téléphonie sur les ponts d'alimentation d'une ligne d'abonné dont chaque branche comprend une résistance pouvant prendre des valeurs allant de 55 à 205 ohms pour des valeurs résistives en continu de la branche variant selon les pays de 150 à 400 ohms.

Les surcharges d'origines diverses survenant sur la ligne peuvent être entre autres des impulsions de tension élevée de l'ordre de 5 000 volts mais brèves (1 milliseconde) résultant d'une chute de la foudre ou des tensions permanentes de 250 volts environ, aux fréquences industrielles, dues à l'induction électromagnétique provenant d'une dissymétrie sur les lignes à haute tension ou au contact avec les lignes basse tension.

Si l'on suppose par exemple qu'une surcharge permanente de 300 volts efficaces à la fréquence de 50 Hz est appliquée sur la ligne, il passe dans chaque branche du pont ayant une impédance continue de 150 ohms (valeur normalisée sur le réseau français) un courant de 2 Ampères qui dissipe dans chaque résistance, ayant par exemple une valeur de 50 ohms, une puissance de 200 watts. Le temps de réponse de la thermistance de protection en série avec ladite résistance étant de l'ordre de la seconde, l'énergie correspondante peut ainsi atteindre la valeur considérable de 200 joules.

Les résistances utilisées jusqu'à présent dans les ponts d'alimentation de lignes téléphoniques ne peuvent garantir la sécurité ou la fiabilité requise lorsqu'elles sont soumises à de telles contraintes.

Les résistances bobinées ont une bonne fiabilité mais elles sont inflammables. Leur emploi s'avère dangereux et impose une vigilance constante.

Les résistances à couches sont ininflammables mais leur fiabilité est très mauvaise. Elles interviennent lourdement sur la fiabilité du système et surtout sur la disponibilité au niveau des équipements individuels d'abonné.

Les résistances réalisées par sérigraphie d'une couche résistante épaisse sur un support isolant ne présentent pas les inconvénients des résistances bobinées et des résistances à couches. La demande de brevet européen N° 0 048 940 à considérer selon l'article 54 paragraphe 3 de la convention, prévoit par exemple l'utilisation de telles résistances dans un module complexe comportant un pont d'alimentation.

Le but de l'invention est d'adapter le procédé connu de réalisation de résistances obtenues par sérigraphie d'une couche résistante épaisse sur un même support isolant à une réalisation du pont résistif qui permet d'obtenir les performances d'ininflammabilité et de fiabilité exigées lorsque ce pont est soumis aux surcharges accidentelles survenant en cours d'exploitation.

Le procédé selon l'invention est appliqué à la réalisation d'un pont d'alimentation d'une ligne d'abonné constitué de deux branches identiques comportant chacune en série entre la batterie centrale et ladite ligne d'abonné une résistance et une thermistance de protection, lesdites résistances du pont d'alimentation étant réalisées simultanément par sérigraphie d'une couche résistance épaisse sur un même support isolant, chacune desdites résistances de forme rectangulaire étant disposée entre deux bandes de connexion d'une matière conductrice de façon à assurer le parallélisme des lignes de courant suivant un côté de la couche rectangulaire, lesdites bandes de connexion étant déposées sur le support isolant de la même façon que la couche résistante, chacune desdites résistances étant ajustable à une valeur prédéterminée en éliminant une partie de la résistance par coupure de ladite couche résistante et desdites bandes de connexion conductrices suivant une même ligne dans le sens dudit côté de la couche rectangulaire, la forme de la résistance ainsi ajustée étant telle qu'il ne se produit pas de resserrement des lignes de courant, le parallélisme desdites lignes étant maintenu, l'épaisseur dudit support isolant étant déterminée en tenant compte du temps de réponse de chacune desdites thermistances. Ledit support isolant est constitué par exemple d'une matière céramique et un calcul thermique tenant compte desdites surcharges a été effectué pour en déterminer l'épaisseur comprise entre 2 et 3 millimètres.

La description suivante en regard des dessins annexés, le tout donné à titre d'exemple fera bien comprendre comment l'invention peut être réalisée.

La figure 1 représente un schéma de pont d'alimentation d'une ligne téléphonique.

La figure 2 montre une vue de dessus de la réalisation du pont résistif conforme à l'invention.

Les figures 3a et 3b illustrent deux méthodes d'ajustage d'une résistance du pont.

La figure 4 fournit les données et résultats d'une étude thermique effectuée sur un échantillon de céramique d'épaisseur donnée (figure 4a) soumis suivant une direction normale à l'une de ses faces à un essai cumulatif de chocs thermiques d'amplitudes constantes ayant la variation en fonction du temps représentée sur la figure 4b et à laquelle correspond la variation théorique de température dont l'allure est indiquée sur les figures 4c et 4d.

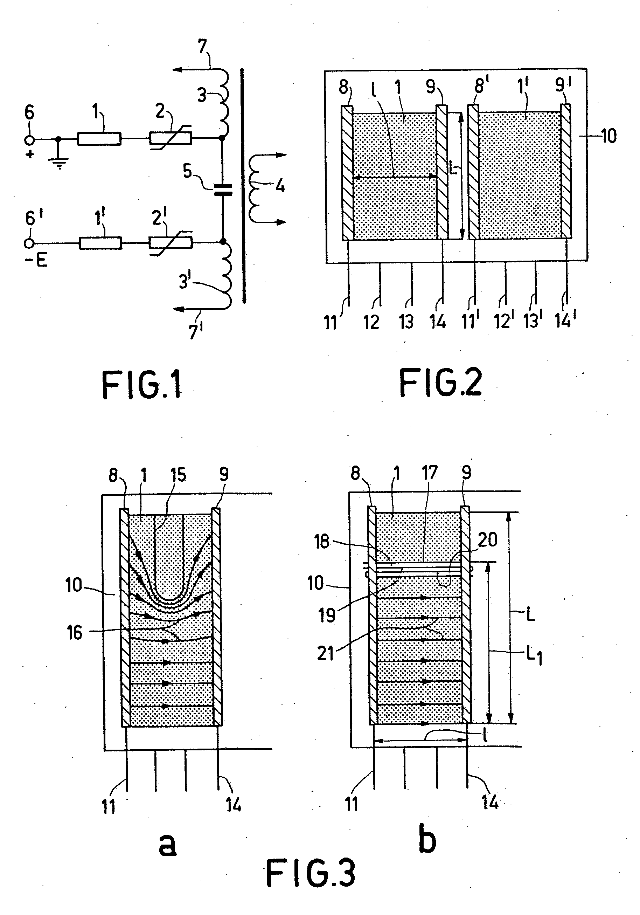

La figure 1 donne la configuration d'un pont d'alimentation classique d'une ligne d'abonné dont l'une des branches comprend à partir de la borne positive 6 de la batterie centrale reliée à la masse, une résistance 1 en série avec une thermistance de protection 2 et un demi-enroulement primaire 3 du transformateur qui transmet les courants de conversation et dont le secondaire 4 est relié au central. On retrouve sur l'autre branche à partir de la borne négative 6' de la batterie portée au potentiel − E les éléments symétriques correspondants 1', 2' et 3'. Les points communs à la thermistance 2 et au demi-enroulement primaire 3 d'une part, à la thermistance 2' et au demi-enroulement primaire 3' d'autre part sont interconnectés par le condensateur 5 bloquant le continu et constituant un court-circuit aux fréquences vocales, tandis que les deux autres extrémités des demi-enroulements primaires sont reliées respectivement aux fils 7 et 7' de la ligne d'abonné.

Les résistances I et I' sont constituées le plus souvent par des résistances bobinées très fiables qui en cas de surcharge s'enflamment rarement par elles-mêmes mais s'échauffent et rougissent sans se couper, risquant ainsi de provoquer l'incendie du matériel électronique environnant.

Afin de pallier ce grave inconvénient, la présente invention substitue à ces résistances bobinées le pont résistif représenté en vue de dessus sur la figure 2 et formé des deux résistances I et I' réalisées simultanément par sérigraphie en couche épaisse d'une encre résistante déposée entre les bandes de connexions 8 et 9 d'une part, 8' et 9' d'autre part obtenues par des sérigraphies d'encres conductrices sur un même support de céramique 10 dont l'épaisseur a été calculée afin de résister à des chocs thermiques de durées au moins égales au temps de réponse des thermistances 2 et 2'.

Les résistances I et I' dont les dimensions sont $\ell$ entre les bandes de connexion et L ont pour valeur R = $R_0$ $\ell$/L, la résistance par carré $R_0$ de la couche étant le quotient de sa résistivité par son épaisseur. Les dimensions couramment utilisées sont $\ell$ = 7 mm et L = 10 mm.

Un connecteur de huit fils métalliques repérés de 11 à 14 et de 11' à 14' et régulièrement espacés au pas normalisé de 2,54 mm est fixé sur le support de céramique, quatre d'entre eux repérés 11, 14 et 11', 14' étant reliés par soudures aux bandes de connexions 8, 9 et 8', 9' respectivement. Les quatre autres sont conservés parce qu'ils contribuent partiellement à l'évacuation de la chaleur accumulée dans la céramique lors des chocs thermiques qu'elle doit supporter ; ils agissent ainsi comme radiateurs.

Sur la figure 3, deux méthodes d'ajustage de la valeur des résistances obtenues par élimination d'une partie de la couche résistante sont indiquées. La première méthode habituellement utilisée consiste (figure 3a) à pratiquer une encoche 15 dans la couche résistante I. La configuration des lignes de courant fait apparaître un resserrement de ces lignes 16 à la base de l'encoche provoquant dans cette zone un échauffement plus élevé qui est transmis à la céramique sous-jacente. Une telle méthode ne peut convenir pour des utilisations imposant à la céramique des chocs thermiques importants. La seconde méthode, conforme à l'invention, est indiquée sur la figure 3b. L'expression donnée ci-dessus de la valeur R de la résistance montre qu'on peut la modifier en agissant sur l'une ou l'autre de ses dimensions. La réalisation proposée impose d'agir sur L. On calcule d'abord une valeur approchée par défaut qui fixe une valeur de largeur $L_1$ et dans un premier temps on réalise un ajustage grossier en isolant la zone correspondant à L $\geqslant$ $L_1$ par coupure de la couche résistante ‖ et des bandes de connexions conductrices 8 et 9 au jet de sable ou au laser suivant une ligne horizontale 17 supérieure à sa longueur $\ell$. Dans un deuxième temps, les fils de connexion 11 et 14 étant reliés à un dispositif de mesure non représenté, on réalise un ajustage fin en découpant au rayon laser des tranches successives de couches résistantes 18, 19, 20 isolées de la même façon et distantes d'environ 200 microns jusqu'à l'obtention de la valeur désirée. Cette méthode d'ajustage qui ne perturbe pas le parallélisme des lignes de courant 21 dans la résistance évite ainsi la formation de points chauds dans le support de céramique.

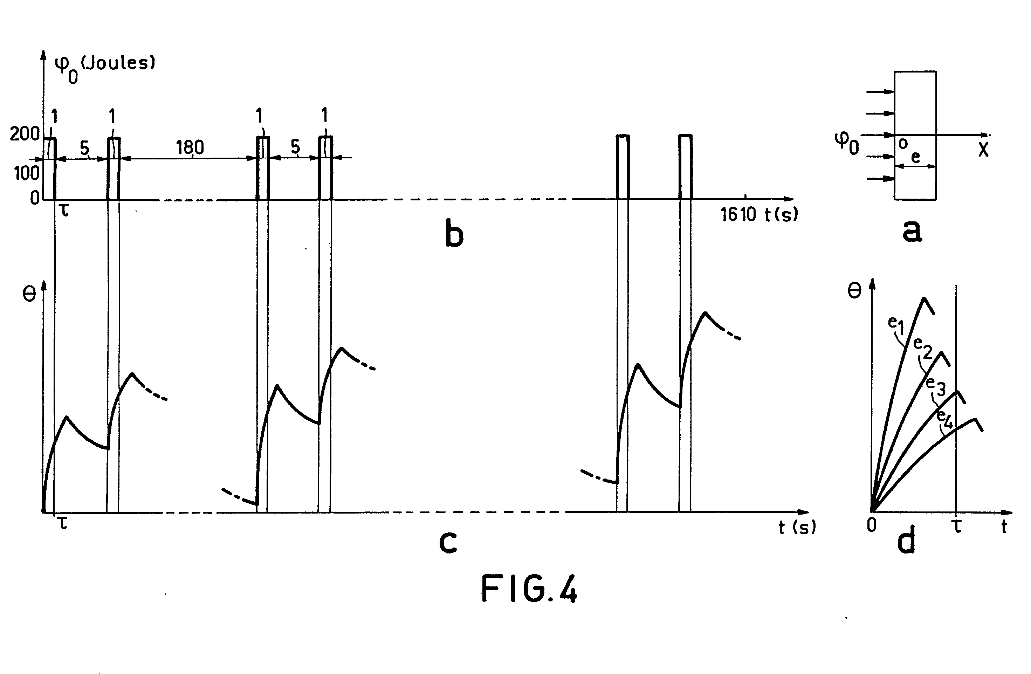

La figure 4 fournit les données et les résultats de l'étude thermique effectuée sur un échantillon de céramique d'épaisseur e auquel est appliqué le flux thermique $\varphi_0$ suivant une direction normale à l'une de ses faces (figure 4a). Cet échantillon doit tenir pendant 1 610 secondes l'essai cumulatif de chocs thermiques dont le cycle se compose de deux impulsions thermiques d'amplitudes $\varphi_0$ = 200 joules d'une durée de 1 seconde, espacées de 5 secondes et suivies d'un temps de repos de 180 secondes (figure 4b). Le problème se ramène à la résolution de l'équation générale de propagation de la chaleur

$$\frac{d\theta}{dt} = a\frac{d^2\theta}{dx^2}$$

afin d'obtenir dans un échantillon donné la température $\theta$ dans la céramique en fonction du temps t et suivant la direction x, a = $\lambda/\rho C_p$ étant la diffusivité thermique, $\lambda$ la conductibilité, $\rho$ le poids spécifique et $C_p$ la chaleur spécifique. Avec les conditions initiales et aux limites résultant des figures 4a et 4b, on obtient :

$$\theta(x, t) = \frac{4\,\varphi_0}{\lambda} \sum_{n=1}^{\infty} \frac{K_n^2\,\lambda^2 + h^2}{K_n^2(eK_n^2\,\lambda^2 + eh^2 + \lambda h)} (1 - e^{-K_n^2 aT}) \cos K_n x$$

T étant le temps de signal, h le coefficient de Newton et n le nombre théoriquement infini de solutions $K_n$ de l'équation

$$K_n \text{ et } gK_n e = he/\lambda.$$

**0 078 089**

Sans entrer dans le détail des résultats de calculs, la figure 4c donnant l'allure de la variation de la température en fonction, du temps montre bien l'effet cumulatif produit. Sur la figure 4d, l'échelle du temps a été dilatée afin d'étaler à partir de l'instant initial les montées en température correspondant à la première impulsion thermique pour différentes épaisseurs de céramique croissant de $e_1$ à $e_4$. Pour les épaisseurs les plus faibles, la température atteint son maximum en un temps inférieur à la durée $\tau$ de l'impulsion thermique. L'expérience a prouvé que dans ce cas l'essai cumulatif de chocs thermiques est destructif. Par contre l'échantillon de céramique résiste à l'essai si son épaisseur est telle que le maximum de température se produit au-delà de $t = \tau$. Dans un pont d'abonné d'une ligne téléphonique, $\tau$ n'est autre que le temps de réponse de la thermistance CTP en série avec la résistance dans chaque branche du pont.

**Revendications**

1. Procédé de réalisation d'un pont d'alimentation d'une ligne d'abonné pouvant être soumis à des surcharges importantes et constitué de deux branches identiques comportant chacune en série entre la batterie centrale et ladite ligne d'abonné une résistance et une thermistance de protection, lesdites résistances du pont d'alimentation étant réalisées simultanément par sérigraphie d'une couche résistante épaisse sur un même support isolant, chacune desdites résistances de forme rectangulaire étant disposée entre deux bandes de connexion d'une matière conductrice de façon à assurer le parallélisme des lignes de courant suivant un côté de la couche rectangulaire, lesdites bandes de connexion étant déposées sur le support isolant de la même façon que la couche résistante, chacune desdites résistances étant ajustable à une valeur prédéterminée en éliminant une partie de la résistance par coupure de ladite couche résistante et desdites bandes de connexion conductrices suivant une même ligne dans le sens dudit côté de la couche rectangulaire, la forme de la résistance ainsi ajustée étant telle qu'il ne se produit pas de resserrement des lignes de courant, le parallélisme desdites lignes étant maintenu, l'épaisseur dudit support isolant étant déterminée en tenant compte du temps de réponse de chacune desdites thermistances.

2. Procédé selon la revendication 1, caractérisé en ce que ledit support isolant est constitué par une matière céramique d'épaisseur comprise entre 2 et 3 millimètres.

3. Procédé selon la revendication 1, caractérisé en ce que ledit ajustage est réalisé en deux temps, un premier temps correspondant à un ajustage grossier au cours duquel la majeure partie de la couche résistante devant être éliminée est isolée par coupure au jet de sable ou au laser, et un deuxième temps correspondant à un ajustage fin au cours duquel la partie restante est découpée au rayon laser en tranches successives régulièrement espacées et isolées de la même façon jusqu'à l'obtention de la valeur de résistance désirée.

4. Procédé selon la revendication 3, caractérisé en ce que l'espace desdites tranches est d'environ 200 microns.

5. Pont d'alimentation réalisé par le procédé selon l'une des revendications 1 à 4.

**Claims**

1. A method of forming a subscriber's line supply bridge which can be subjected to high overloads and is constituted by two identical branches, each comprising a resistor and a protection thermistor, arranged in series between the central battery and said subscriber's line, said resistors of the supply bridge being formed simultaneously by silk-screen printing of a thick resistant layer on the same insulating support, each of these resistors of a rectangular shape being interposed between two connection strips of a conductive material so as to ensure parallelism of the current lines along one side of the rectangular layer, said connection strips being deposited on the insulating support in the same way as the resistant layer, each of the said resistors being adjustable to a predetermined value by removing a part of the resistance by cutting said resistant layer and said conductive connection strips following the same line in the direction of said side of the rectangular layer, the shape of the resistor thus adjusted being such that no concentration of the current lines occurs, the parallelism of said lines being maintained, the thickness of said insulating support being determined by taking account of the response time of each of said thermistors.

2. A method as claimed in Claim 1, characterized in that said insulating support is constituted by a ceramic material having a thickness between 2 and 3 mm.

3. A method as claimed in Claim 1, characterized in that said adjustment is effected in two steps, a first step corresponding to a coarse adjustment during which the major part of the resistant layer, before being removed, is insulated by cutting it by means of sand-blasting or by means of a laser, and a second step corresponding to a fine adjustment during which the remaining part is cut by means of a laser beam into successive layer parts which are regularly spaced apart and insulated in the same manner until the desired resistance value has been obtained.

4

**0 078 089**

4. A method as claimed in Claim 3, characterized in that the said layer parts are spaced apart by approximately 200 μm.

5. A supply bridge formed by means of the method claimed in any one of Claims 1 to 4.

## Patentansprüche

1. Verfahren zum Bilden einer Teilnehmerleitungsspeisebrücke, die hohen Überlastungen ausgesetzt werden kann und aus zwei identischen Zweigen besteht, die je eine Reihenschaltung aus einem Widerstand und einem Thermistor aufweisen, wobei die Reihenschaltung zwischen der zentralen Batterie und der genannten Teilnehmerleitung liegt, wobei die genannten Widerstände der Speisebrücke im Siebdruckverfahren als dicke Widerstandsschicht auf demselben isolierenden Träger gleichzeitig gebildet werden, wobei jeder dieser Widerstände mit Rechteckform zwischen zwei Verbindungsstreifen aus einem leitenden Material liegt um eine Parallelität der Stromlinien parallel zu einer Seite der rechteckigen Schicht zu gewährleisten, wobei die genannten Verbindungsstreifen auf dieselbe Art und Weise wie die Widerstandsschicht auf dem isolierenden Träger niedergeschlagen werden, wobei jeder der genannten Widerstände durch Entfernung eines Teils des Widerstandes durch Abschneiden der genannten Widerstandsschicht und der genannten Verbindungsstreifen langs eine selbe Linie in Richtung der genannten Seite der Rechteckschicht auf einen vorbestimmten Wert einstellbar ist, wobei die Form des Widerstandes, der auf diese Weise eingestellt ist, derart ist, dass keine Einengung der Stromlinien auftritt und die Parallelität der Linien beibehalten wird und wobei die Dicke des genannten isolierenden Trägers mit Rücksicht auf die Ansprechzeit jedes der genannten Thermistoren bestimmt ist.

2. Verfahren nach Anspruch 1, dadurch gekennzeichnet, dass der genannte isolierende Träger durch ein keramisches Material mit einer Dicke zwischen 2 und 3 mm gebildet ist.

3. Verfahren nach Anspruch 1, dadurch gekennzeichnet, dass die genannte Einstellung in zwei Zeitabschnitten erfolgt und zwar in einem ersten Zeitabschnitt entsprechend einer groben Einstellung, wobei der Hauptteil der zu entfernenden Widerstandsschicht durch Schneiden mittels Sandstrahlen oder mittels eines Lasers isoliert wird und in einem zweiten Zeitabschnitt entsprechend einer Feineinstellung, wobei der restliche Teil mittels eines Laserstrahles in aufeinanderfolgende Schichtteile geschnitten wird, die in regelmässigen Abständen voneinander getrennt und auf dieselbe Art und Weise isoliert sind bis der gewünschte Widerstandswert erhalten worden ist.

4. Verfahren nach Anspruch 3, dadurch gekennzeichnet, dass die genannten Schichtteile in einem Abstand von etwa 200 μm voneinander liegen.

5. Speisebrücke, die nach dem Verfahren nach einem der Ansprüche 1 bis 4 gebildet ist.

5

0 078 089

FIG.1

FIG.2

FIG.3

a

b

FIG.4